# EUROPEAN PATENT APPLICATION

(11) **EP 4 439 624 A1**
(43) Date of publication of application: **02.10.2024**
(21) Application number: 24157946.5
(22) Date of filing: 15.02.2024
(51) Int. Cl.: H01J 37/20, H01J 37/26, H01J 37/28, G01N 1/28

(54) **SAMPLE HOLDER AND SAMPLE PROCESSING APPARATUS**

(30) Priority: 27.03.2023 JP 2023050125
(71) Applicant: Jeol Ltd., Akishima-shi, Tokyo 196-8558 (JP)
(72) Inventor: WATANABE, Jun, Tokyo, 196-8558 (JP); KIMURA, Tatsuhito, Tokyo, 196-8558 (JP); FUKUDA, Tomohisa, Tokyo, 196-8558 (JP); NEGISHI, Tsutomu, Tokyo, 196-8558 (JP)
(74) Representative: Boult Wade Tennant LLP

(57) **Abstract**

A sample holder (100) used for a sample processing apparatus that applies a charged particle beam to a sample (S) to process the sample (S), the sample (100) including a holder base (20) thermally connected to a cooling source (2), a rotating body rotatably supported on the holder base (20) to hold the sample (S), and a drive unit that rotates the rotating body, and the rotating body having a sliding surface (30a) that comes into slidable surface contact with the holder base (20).

## Description

### BACKGROUND OF THE INVENTION

### Field of the Invention

The present invention relates to a sample holder and a sample processing apparatus.

### Description of Related Art

As a sample processing apparatus that uses an ion beam to process a sample, a Cross Section Polisher (registered trademark) for processing a cross section of the sample, an Ion Slicer (registered trademark) for producing a thin-film sample, and the like are known.

JP-A-2016-100111 discloses a sample processing apparatus including a sample holder capable of changing an incidence angle of an ion beam with respect to a sample.

As a technique of using an ion beam to process a sample, planar surface milling is known. In the planar surface milling, an ion beam is obliquely applied to a surface of a rotating sample to allow polishing flaws and crystal distortion caused by mechanical polishing to be removed in a wide range and allow an excellently smooth surface to be produced. By observing the sample produced using the planar surface milling with a scanning electron microscope, crystal information of an outermost surface of the sample can be obtained.

However, in a polymer or low-melting-point metal sample or the like sensitive to heat, an application of an ion beam causes thermal damage, and consequently, even when the planar surface milling is performed on the sample, an excellently smooth surface may not be able to be produced.

### SUMMARY OF THE INVENTION

According to a first aspect of the present disclosure, there is provided a sample holder used for a sample processing apparatus that applies a charged particle beam to a sample to process the sample, the sample holder including:
a holder base thermally connected to a cooling source;
a rotating body rotatably supported on the holder base to hold the sample; and
a drive unit that rotates the rotating body, and
the rotating body having a sliding surface that comes into slidable surface contact with the holder base.

According to a second aspect of the present disclosure, there is provided a sample processing apparatus including:
the above sample holder; and
a charged particle beam source that applies a charged particle beam to the sample held on the sample holder.

### BRIEF DESCRIPTION OF THE DRAWINGS

FIG. 1 is a perspective view schematically illustrating a sample holder according to the first embodiment.
FIG. 2 is a perspective view schematically illustrating the sample holder according to the first embodiment.
FIG. 3 is a cross-sectional view schematically illustrating the sample holder according to the first embodiment.
FIG. 4 is a plan view schematically illustrating the sample holder according to the first embodiment.
FIG. 5 is a cross-sectional view schematically illustrating a sample holder according to a first modification.
FIG. 6 is a cross-sectional view schematically illustrating a sample holder according to a second modification.
FIG. 7 is a cross-sectional view schematically illustrating a sample holder according to a third modification.
FIG. 8 is a perspective view schematically illustrating a holding member.
FIG. 9 is a cross-sectional view schematically illustrating a sample holder according to a fourth modification.
FIG. 10 is a perspective view schematically illustrating a sample holder according to a fifth modification.
FIG. 11 is a cross-sectional view schematically illustrating a sample holder according to a sixth modification.
FIG. 12 is a perspective view schematically illustrating a sample holder according to the second embodiment.
FIG. 13 is a perspective view schematically illustrating the sample holder according to the second embodiment.
FIG. 14 is a cross-sectional view schematically illustrating the sample holder according to the second embodiment.
FIG. 15 is a diagram illustrating a configuration of a sample processing apparatus according to the third embodiment.
FIG. 16 is a flow chart illustrating an example of a sample processing method.

### DESCRIPTION OF THE INVENTION

According to an embodiment of the present disclosure, there is provided a sample holder used for a sample processing apparatus that applies a charged particle beam to a sample to process the sample, the sample holder including:
a holder base thermally connected to a cooling source;
a rotating body rotatably supported on the holder base to hold the sample; and
a drive unit that rotates the rotating body, and
the rotating body having a sliding surface that comes into slidable surface contact with the holder base.

In such a sample holder, a rotating body has a sliding surface that comes into slidable surface contact with a holder base, and accordingly it is possible to efficiently cool the holder, while rotating the holder. As a result, in such a sample holder, it is possible to reduce thermal damage given by an application of a charged particle beam to a sample and therefore produce an excellently smooth surface by planar surface milling.

According to an embodiment of the present disclosure, there is provided a sample processing apparatus including:
the above sample holder; and
a charged particle beam source that applies a charged particle beam to the sample held on the sample holder.

In such a sample processing apparatus, the sample holder described above is included, and accordingly it is possible to reduce thermal damage given by an application of a charged particle beam to the sample and produce an excellently smooth surface by the planar surface milling.

Now preferred embodiments of the invention will be described in detail below with reference to the drawings. The embodiments described below are not intended to unduly limit the scope of the invention as stated in the claims. Further, all of the components described below are not necessarily essential requirements of the invention.

### 1. First Embodiment

### 1.1. Configuration of Sample Holder

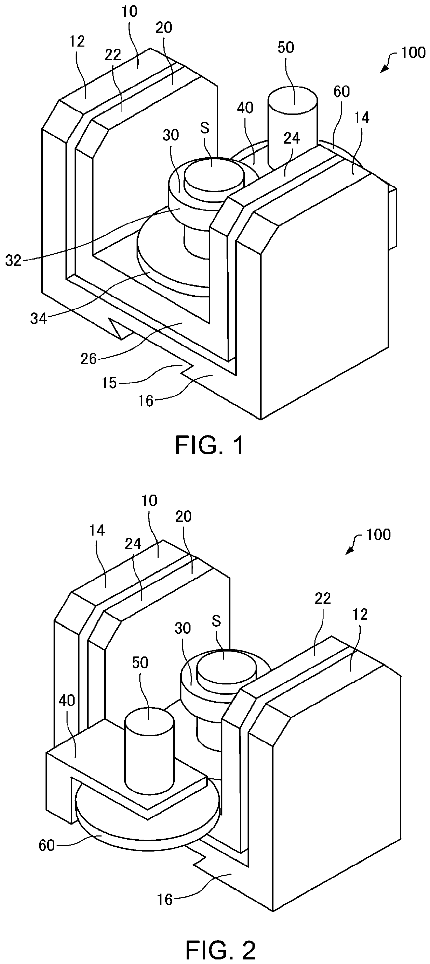

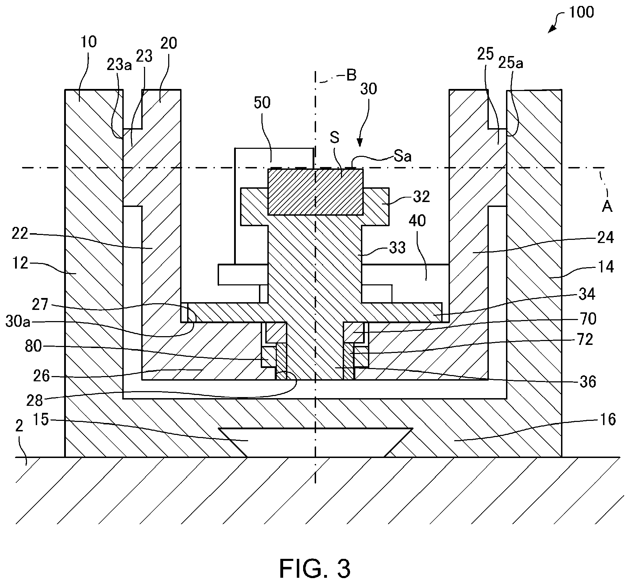

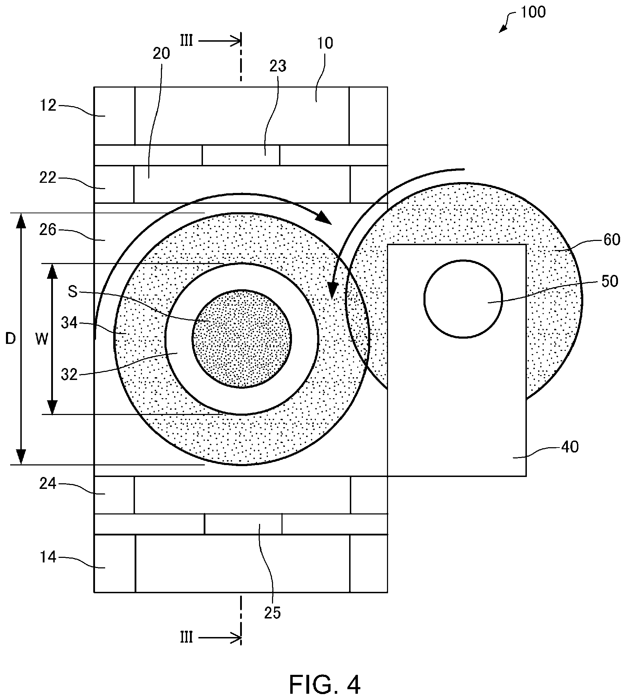

First, referring to the drawings, a description will be given of a sample holder according to the first embodiment. FIGS. 1 and 2 are perspective views schematically illustrating a sample holder 100 according to the first embodiment. FIG. 3 is a cross-sectional view schematically illustrating the sample holder 100 according to the first embodiment. FIG. 4 is a plan view schematically illustrating the sample holder 100. Note that FIG. 3 is a cross-sectional view along a line III-III in FIG. 4.

The sample holder 100 is a sample holder for a sample processing apparatus that applies an ion beam to a sample S to process the sample S. As illustrated in FIGS. 1 to 4, the sample holder 100 includes a base 10, a holder base 20, a holder 30, a motor base 40, a motor 50, a first gear 60, a magnet 70, and a magnetic body 80.

The base 10 has a wall portion 12, a wall portion 14, and a bottom portion 16 connecting the wall portion 12 and the wall portion 14. The wall portion 12 and the wall portion 14 face each other. Between the wall portion 12 and the wall portion 14, the holder base 20 is disposed.

The base 10 is configured to be detachable from the sample processing apparatus. For example, in the bottom portion 16 of the base 10, a recessed portion 15 is formed. Into the recessed portion 15, a protruding portion provided on a stage of the sample processing apparatus is fitted to allow the base 10 to be attached to the sample processing apparatus. Note that a method of attaching the base 10 to the sample processing apparatus is not particularly limited.

As illustrated in FIG. 3, the base 10 is thermally connected to a cooling source 2 and cooled by heat transfer. The bottom portion 16 of the base 10 is in surface contact with the cooling source 2. In the sample processing apparatus, a stage to which the base 10 is to be attached is cooled by a refrigerant such as liquid nitrogen, and the stage serves as the cooling source 2.

The holder base 20 has a first wall portion 22, a second wall portion 24, and a bottom portion 26 connecting the first wall portion 22 and the second wall portion 24. The first wall portion 22 and the second wall portion 24 face each other. Between the first wall portion 22 and the second wall portion 24, the holder 30 that holds the sample S is disposed.

The wall portion 12 of the base 10 and the first wall portion 22 of the holder base 20 face each other and, between the wall portion 12 and the first wall portion 22, there is a gap. The wall portion 14 of the base 10 and the second wall portion 24 of the holder base 20 face each other and, between the wall portion 14 and the second wall portion 24, there is a gap. The bottom portion 16 of the base 10 and the bottom portion 26 of the holder base 20 face each other and, between the bottom portion 16 and the bottom portion 26, there is a gap.

The holder base 20 is thermally connected to the base 10. The holder base 20 is thermally connected to the cooling source 2 via the base 10 and cooled by heat transfer. The first wall portion 22 is provided with a first protruding portion 23 protruding toward the wall portion 12 of the base 10. A leading end surface 23a of the first protruding portion 23 is in slidable surface contact with the wall portion 12. The second wall portion 24 is provided with a second protruding portion 25 protruding toward the wall portion 14 of the base 10. A leading end surface 25a of the second protruding portion 25 is in slidable surface contact with the wall portion 14. The surface contact of the first protruding portion 23 and the second protruding portion 25 with the base 10 thermally connects the holder base 20 to the base 10. Thus, the holder base 20 is thermally connected to the cooling source 2 via the base 10.

In the bottom portion 26 of the holder base 20, a hole 28 is formed to guide a shaft portion 36 of the holder 30. In addition, the bottom portion 26 has a bottom surface 27 with which a sliding surface 30a of the holder 30 comes into slidable surface contact.

The holder base 20 is connected to the base 10 to be able to be inclined. The holder base 20 is inclined using an axis A illustrated in FIG. 3 as an inclination axis. The first protruding portion 23 and the second protruding portion 25 are rotatably connected to the base 10 via rod-shaped shaft members each extending along the axis A. This allows the holder base 20 to be inclined using the axis A as the inclination axis. The holder base 20 may also be inclined manually or using the motor not shown as power. By inclining the holder base 20, it is possible to incline the holder 30, the motor base 40, and the motor 50. By inclining the holder base 20, it is possible to incline the sample S.

The holder 30 holds the sample S serving as a processing target. The holder 30 is rotatably supported on the holder base 20. The holder 30 is a rotating body rotated by a drive of the motor 50. The holder 30 has the sliding surface 30a that comes into slidable surface contact with the holder base 20.

The holder 30 has a sample holding portion 32, a columnar portion 33, a second gear 34, and the shaft portion 36. For example, the sample holding portion 32, the columnar portion 33, the second gear 34, and the shaft portion 36 are integrally configured.

The sample holding portion 32 holds the sample S. The sample holding portion 32 is located between the first wall portion 22 and the second wall portion 24 of the holder base 20. The sample S is fixed to the sample holding portion 32 such that the axis A serving as the inclination axis of the holder base 20 passes through a surface Sa of the sample S. The sample S may be fixed to the sample holding portion 32 by using, e.g., a resin or an adhesive, and may also be fixed to the sample holding portion 32 by using a spring, a screw, or the like. A shape of the sample holding portion 32 is a circle when viewed in a direction along an axis B. Note that the shape of the sample holding portion 32 is not particularly limited, and may also be a polygon when viewed in the direction along the axis B.

The columnar portion 33 is a column-shaped portion extending along the axis B. The shape of the columnar portion 33 is a columnar shape around the axis B serving as a center axis. To one end of the columnar portion 33, the sample holding portion 32 is connected while, to another end of the columnar portion 33, the second gear 34 and the shaft portion 36 are connected.

The second gear 34 meshes with the first gear 60. The second gear 34 is rotated by power transmitted thereto from the first gear 60. The second gear 34 is, e.g., a spur gear. A center of the second gear 34 is located on the axis B serving as a rotation axis of the holder 30. The second gear 34 has the sliding surface 30a that comes into slidable surface contact with the holder base 20. The sliding surface 30a is a circular region around the axis B. A plurality of teeth included in the second gear 34 are formed around the sliding surface 30a.

A maximum diameter (maximal diameter) D of the second gear 34 illustrated in FIG. 4 is larger than a maximum width W of the sample holding portion 32. The maximum width W of the sample holding portion 32 has a dimension in a direction perpendicular to the axis B of the sample holding portion 32. The shape of the sample holding portion 32 is the circle herein when viewed in the direction along the axis B, and the maximum width W is a maximum diameter of the sample holding portion 32.

When viewed in the direction along the axis B, the second gear 34 has a largest width (dimension in the direction perpendicular to the axis B) in the holder 30. In other words, when viewed in the direction along the axis B, the maximum diameter D of the second gear 34 is larger than each of the maximum width W of the sample holding portion 32, a maximum width (maximum diameter) of the columnar portion 33, and a maximum width (maximum diameter) of the shaft portion 36. By setting the maximum diameter D of the second gear 34 large, it is possible to increase an area of the sliding surface 30a. This can increase an area over which the holder 30 and the holder base 20 are in surface contact with each other, and increase a cooling efficiency.

The shaft portion 36 is inserted in the hole 28 of the holder base 20. By inserting the shaft portion 36 into the hole 28, the holder 30 can be attached to the holder base 20. The holder 30 rotates, while being guided by the hole 28 in which the shaft portion 36 is inserted. A center axis of the shaft portion 36 overlaps the axis B. The holder 30 rotates around the axis B serving as the rotation axis.

To the shaft portion 36, the magnet 70 is fixed. In the illustrated example, the magnet 70 is fixed to the shaft portion 36 with a nut 72. The nut 72 screws over a male screw formed in the shaft portion 36. For example, the magnet 70 has a circular shape when viewed in the direction along the axis B, and the shaft portion 36 passes through a center of a circle. Meanwhile, into the hole 28 of the holder base 20, the magnetic body (ferromagnetic body) 80 is fixed. For example, the magnetic body 80 has a circular shape when viewed in the direction along the axis B, and the shaft portion 36 passes through a center of a circle.

By a magnetic force generated by the magnet 70, the sliding surface 30a of the holder 30 comes into close contact with the bottom surface 27 of the holder base 20. By an attraction force acting between the magnet 70 and the magnetic body 80, the sliding surface 30a is pressed against the bottom surface 27 to come into close contact with the bottom surface 27. The sliding surface 30a is pressed by a predetermined magnetic force of the magnet 70 against the bottom surface 27.

The holder 30 is held on the holder base 20 by the attraction force between the magnet 70 and the magnetic body 80. Accordingly, the holder 30 is detachable from the holder base 20. Therefore, in the sample holder 100, the sample S can be fixed to the holder 30 in a state where the holder 30 is detached from the holder base 20. In addition, when the holder 30 is worn out, the holder 30 can be replaced.

A material of the base 10 and the holder base 20 is, e.g., aluminum, while a material of the holder 30 is, e.g., copper. By using different types of metals as the material of the holder base 20 and the material of the holder 30, it is possible to prevent galling. Note that the materials of the base 10, the holder base 20, and the holder 30 are not particularly limited as long as the materials have high heat conductivities. For example, it may be possible to cover each of a base material of the holder base 20 and a base material of the holder 30 with a plate layer to allow each of the bottom surface 27 of the holder base 20 and the sliding surface 30a of the holder 30 to have a plated layer surface. For example, it may also be possible to use a plated layer surface with a high slidability and a high heat conductivity as each of the bottom surface 27 of the holder base 20 and the sliding surface 30a of the holder 30.

The motor base 40 holds the motor 50. The motor base 40 is connected to the holder base 20. The motor 50 is connected to the first gear 60. The motor 50 rotates the first gear 60. The motor 50 functions as a drive unit for rotating the holder 30. The first gear 60 is, e.g., a spur gears.

### 1.2. Operation of Sample Holder

In the sample holder 100, by inclining the holder base 20 by using the axis A as the inclination axis, it is possible to adjust an incidence angle of an ion beam with respect to the surface Sa of the sample S.

When the first gear 60 is rotated by rotation of the motor 50, the second gear 34 meshing with the first gear 60 is rotated. Thus, the holder 30 rotates around the axis B serving as the rotation axis, and the sample S held by the sample holding portion 32 rotates around the axis B serving as the rotation axis. For example, the motor 50 continuously rotates the holder 30 in a predetermined direction. In other words, the motor 50 rotates the holder 30 plurality of times in the same direction.

As a result of the rotation of the holder 30, the sliding surface 30a of the holder 30 slides, while being in surface contact with the bottom surface 27. Since the base 10 is in contact with the cooling source 2 herein, the base 10 is cooled herein by heat transfer. By the cooling of the base 10, the holder base 20 thermally connected to the base 10 is cooled. Since the sliding surface 30a of the holder 30 is in slidable surface contact with the holder base 20, it is possible to cool the holder 30, while rotating the holder 30. At this time, by the attraction force acting between the magnet 70 fixed to the holder 30 and the magnetic body 80 fixed to the holder base 20, the sliding surface 30a is pressed with a predetermined force against the bottom surface 27. This can bring the sliding surface 30a and the bottom surface 27 into close contact with each other.

### 1.3. Functions/Effects

The sample holder 100 includes the holder base 20 thermally connected to the cooling source 2, the holder 30 rotatably supported on the holder base 20 and holding the sample S, and the motor 50 that rotates the holder 30. Meanwhile, the holder 30 has the sliding surface 30a that comes into slidable surface contact with the holder base 20. Thus, in the sample holder 100, the holder 30 has the sliding surface 30a that comes into slidable surface contact with the holder base 20, and therefore it is possible to efficiently cool the holder 30, while rotating the holder 30. As a result, in the sample holder 100, it is possible to reduce thermal damage given by the application of the ion beam to the sample S, and therefore it is possible to produce an excellently smooth surface by the planar surface milling even when the sample is a polymer or low-melting-point metal sample or the like sensitive to heat.

For example, when the holder 30 is rotatably supported on the holder base 20 via a bearing, between the holder base 20 and the holder 30, a portion in point contact with a ball of the bearing is included. As a result, when the holder 30 is supported on the holder base 20 via the bearing, heat transfer is poor, and the holder 30 cannot efficiently be cooled. By contrast, in the sample holder 100, the holder 30 and the holder base 20 are in surface contact with each other, and accordingly heat transfer is excellent, and the holder 30 can efficiently be cooled.

The sample holder 100 includes the magnet 70 that brings the holder 30 into close contact with the holder base 20 by a magnetic force generated by the magnet 70. In the sample holder 100, the magnet 70 is fixed to the holder 30, while the magnetic body 80 is fixed to the holder base 20. Thus, in the sample holder 100, it is possible to magnetically bring the sliding surface 30a of the holder 30 into close contact with the holder base 20, and therefore it is possible to reduce a contact thermal resistance between the sliding surface 30a and the holder base 20 and efficiently cool the holder 30.

In addition, in the sample holder 100, the sliding surface 30a of the holder 30 is brought into close contact with the holder base 20 by the magnetic force generated by the magnet 70, and therefore the sliding surface 30a can be pressed with a predetermined force. This can reduce fluctuations in frictional force occurring across the sliding surface 30a and can reduce fluctuations in contact thermal resistance between the sliding surface 30a and the bottom surface 27.

For example, when the sliding surface 30a is brought into close contact with the holder base 20 by using an elastic member such as a spring, a magnitude of a resilient force of the spring is proportional to an amount of extension/contraction of the spring from a natural length thereof, and therefore it is difficult to press the sliding surface 30a with a predetermined force. By contrast, in the sample holder 100, the sliding surface 30a of the holder 30 is magnetically brought into close contact with the holder base 20, and accordingly the sliding surface 30a can be pressed with a predetermined given force. This can reduce the frictional force fluctuations caused across the sliding surface 30a. In addition, it is possible to reduce the contact thermal resistance fluctuations between the sliding surface 30a and the holder base 20. As a result, in the sample holder 100, the holder 30 can be rotated at a predetermined speed, while a temperature of the holder 30 can be held constant.

The sample holder 100 includes the first gear 60 rotated by the rotation of the motor 50. Meanwhile, the holder 30 includes the sample holding portion 32 that holds the sample S and the second gear 34 rotated by the power transmitted thereto from the first gear 60. Consequently, in the sample holder 100, the holder 30 can continuously be rotated in a predetermined direction.

In the sample holder 100, the sliding surface 30a is a surface of the second gear 34. In addition, the plurality of teeth of the second gear 34 are formed around the sliding surface 30a. Consequently, in the sample holder 100, as a result of the rotation of the holder 30, the sliding surface 30a slides, while being in surface contact with the holder base 20. Therefore, in the sample holder 100, it is possible to bring the holder 30 into surface contact with the holder base 20, while rotating the holder 30.

In the sample holder 100, when viewed in the direction along the axis B, the maximum diameter D of the second gear 34 is larger than the maximum width W of the sample holding portion 32. Accordingly, in the sample holder 100, compared to a case where, e.g., the maximum diameter D of the second gear 34 is equal to or less than the maximum width W of the sample holding portion 32, the area of the sliding surface 30a can be increased to be able to enhance the efficiency of cooling of the holder 30.

In the sample holder 100, the motor 50 continuously rotates the holder 30 in a predetermined direction. As a result, in the sample holder 100, it is possible to reduce uneven processing of the surface Sa of the sample S in the planar surface milling and produce the excellently smooth surface.

For example, when the holder 30 is cooled by connecting the holder 30 and the cooling source 2 with a flat stranded wire, when the holder 30 is continuously rotated in a predetermined direction, the flat stranded wire may be twisted, and consequently the holder 30 cannot continuously be rotated in a predetermined direction. By contrast, in the sample holder 100, the sliding surface 30a of the holder 30 is allowed to slide, while being kept in surface contact with the holder base 20, and consequently it is possible to continuously rotate the holder 30 in a predetermined direction, while cooling the holder 30.

The sample holder 100 includes the base 10 thermally connected to the cooling source 2, the holder base 20 is thermally connected to the cooling source 2 via the base 10, and the holder base 20 is connected to the base 10 to be able to be inclined. Therefore, in the sample holder 100, it is possible to adjust the incidence angle of the ion beam with respect to the surface Sa of the sample S.

### 1.4. Modifications

### 1.4.1. First Modification

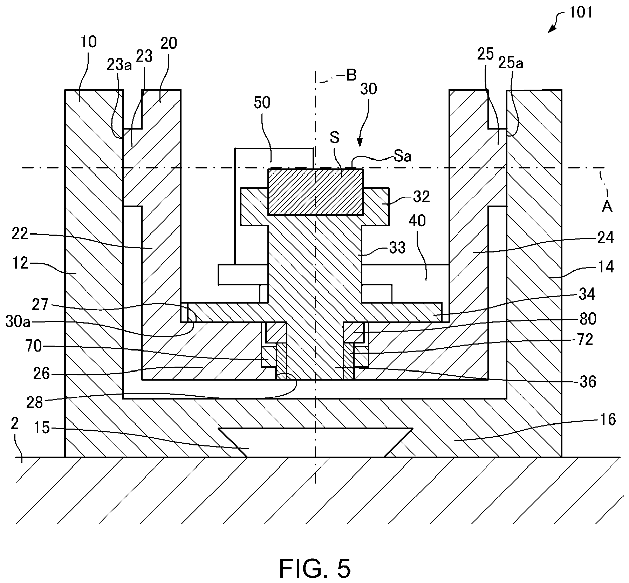

FIG. 5 is a cross-sectional view schematically illustrating a sample holder 101 according to a first modification. Hereinbelow, in the sample holder 101, members having the same functions as those of the constituent members of the sample holder 100 described above are denoted by the same reference signs, and a detailed description thereof is omitted.

In the sample holder 100 described above, as illustrated in FIG. 3, the magnet 70 is fixed to the holder 30, while the magnetic body 80 is fixed to the holder base 20. By contrast, in the sample holder 101, as illustrated in FIG. 5, the magnet 70 is fixed to the holder base 20, while the magnetic body 80 is fixed to the holder 30.

The sample holder 101 can achieve the same functions/effects as those achieved by the sample holder 100.

### 1.4.2. Second Modification

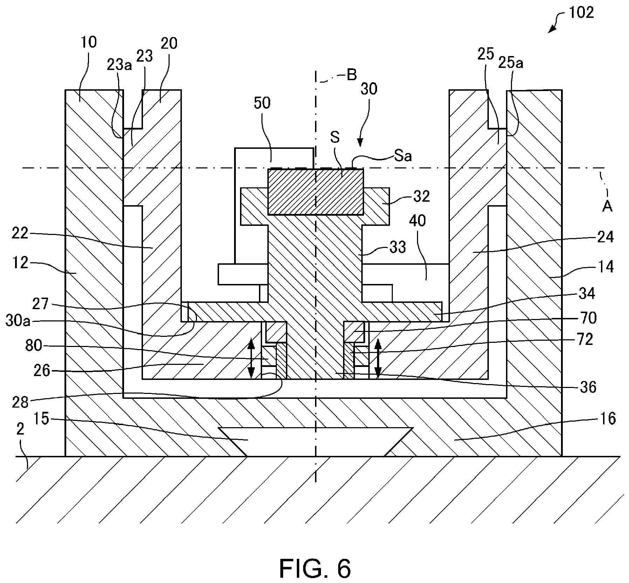

FIG. 6 is a cross-sectional view schematically illustrating a sample holder 102 according to the second modification. Hereinbelow, in the sample holder 102, members having the same functions as those of the constituent members of the sample holder 100 described above are denoted by the same reference signs, and a detailed description thereof is omitted.

In the sample holder 100 described above, as illustrated in FIG. 3, the magnet 70 is fixed to the holder 30, while the magnetic body 80 is fixed to the holder base 20. Accordingly, in the sample holder 100, a distance between the magnet 70 and the magnetic body 80 is constant.

By contrast, in the sample holder 102, as illustrated in FIG. 6, the magnetic body 80 can move along the axis B. Consequently, in the sample holder 102, the distance between the magnet 70 and the magnetic body 80 can be varied. The magnet 70 is fixed to the holder 30.

In an inner surface of the hole 28 formed in the bottom portion 26 of the holder base 20, a female screw is formed while, in an outer surface of the magnetic body 80, a male screw is formed. By thus providing the magnetic body 80 and the hole 28 with a screw structure, it is possible to move the magnetic body 80 along the axis B. This allows the distance between the magnet 70 and the magnetic body 80 to be varied.

Alternatively, the magnetic body 80 may also be screwed in place in a direction perpendicular to the axis B, though not shown. Still alternatively, after the distance between the magnet 70 and the magnetic body 80 is adjusted, the magnetic body 80 may also be bonded and fixed.

The sample holder 102 can achieve the same functions/effects as those achieved by the sample holder 100. In addition, in the sample holder 102, the distance between the magnet 70 and the magnetic body 80 is variable. Accordingly, in the sample holder 102, a magnitude of the attraction force between the magnet 70 and the magnetic body 80 can be adjusted. Therefore, in the sample holder 102, a force to press the sliding surface 30a of the holder 30 against the holder base 20 can be adjusted.

Note that, as illustrated in FIG. 5, it may also be possible to fix the magnetic body 80 to the holder 30 and allow the magnet 70 to move along the axis B. This allows the distance between the magnet 70 and the magnetic body 80 to be varied.

### 1.4.3. Third Modification

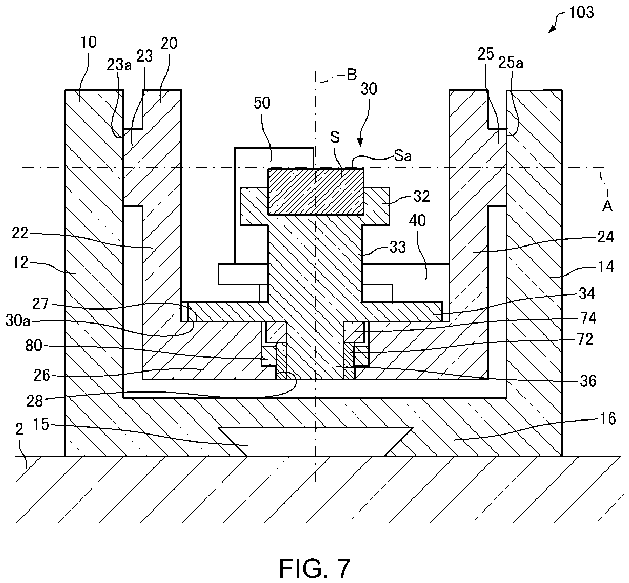

FIG. 7 is a cross-sectional view schematically illustrating a sample holder 103 according to a third modification. Hereinbelow, in the sample holder 103, members having the same functions as those of the constituent members of the sample holder 100 described above are denoted by the same reference signs, and a detailed description thereof is omitted.

In the sample holder 100 described above, when viewed in the direction along the axis B, the magnet 70 has the circular shape. By contrast, in the sample holder 103, a plurality of the magnets 70 are held by a circular holding member 74 and arranged around the shaft portion 36.

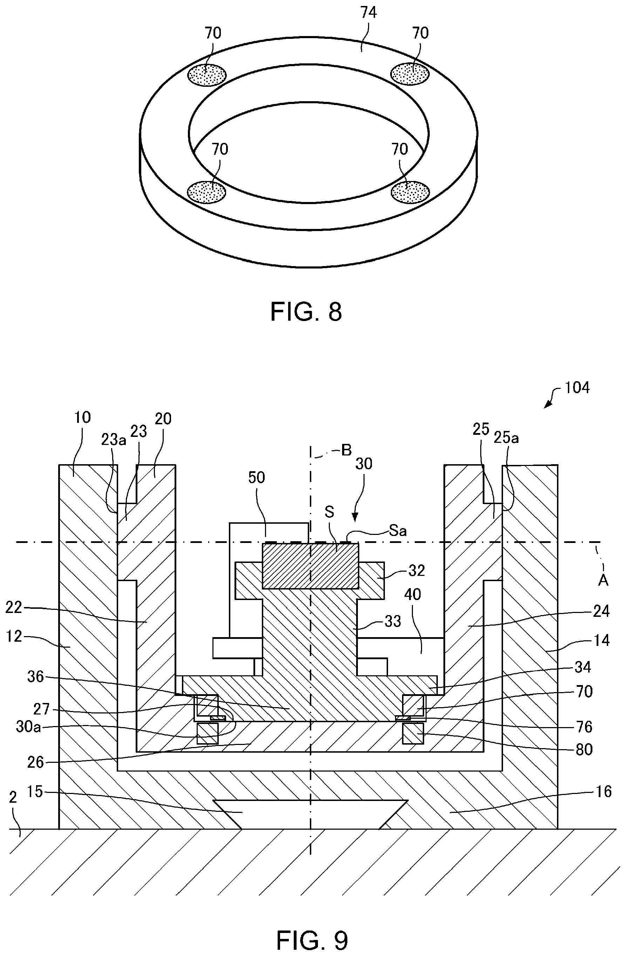

FIG. 8 is a perspective view schematically illustrating the holding member 74. When viewed in the direction along the axis B, the holding member 74 has a circular shape, and the shaft portion 36 passes through a center of a circle. The holding member 74 is fixed to the shaft portion 36 with the nut 72. As illustrated in FIG. 8, the holding member 74 holds the plurality of magnets 70. For example, the magnets 70 are equidistantly arranged around the axis B. In the illustrated example, the holding member 74 holds the four magnets 70, but the number of the magnets 70 to be held by the holding member 74 is not particularly limited. Locations of the magnets 70 are also not particularly limited, and the magnets 70 can be disposed at any positions.

The sample holder 103 can achieve the same functions/effects as those achieved by the sample holder 100.

### 1.4.4. Fourth Modification

FIG. 9 is a cross-sectional view schematically illustrating a sample holder 104 according to a fourth modification. Hereinbelow, in the sample holder 104, members having the same functions as those of the constituent members of the sample holder 100 described above are denoted by the same reference signs, and a detailed description thereof is omitted.

In the sample holder 100 described above, as illustrated in FIG. 3, the sliding surface 30a of the holder 30 is a circular region around the axis B serving as t-he rotation axis of the holder 30. By contrast, in the sample holder 104, as illustrated in FIG. 9, the sliding surface 30a of the holder 30 is a circle around the axis B.

The sliding surface 30a is provided on the shaft portion 36. The sliding surface 30a is an end surface of the shaft portion 36. When viewed in, e.g., the direction along the axis B, the magnet 70 has a circular shape, and the shaft portion 36 passes through a center of a circle. The sliding surface 30a is surrounded by the magnet 70 when viewed in the direction along the axis B. In other words, the sliding surface 30a is located inside the circular magnet 70 when viewed in the direction along the axis B. The magnet 70 is fixed by a fixing member 76 to the holder 30. Note that a method of fixing the magnet 70 is not particularly limited, and the magnet 70 may also be fixed to the holder 30 with, e.g., an adhesive or the like.

The magnetic body 80 is disposed in a region facing the magnet 70. When viewed in the direction along the axis B, the magnetic body 80 overlaps the magnet 70. In the illustrated example, when viewed in, e.g., the direction along the axis B, the magnetic body 80 has a circular shape. For example, the diameter of the magnet 70 and the diameter of the magnetic body 80 are equal. The bottom surface 27 of the holder base 20 that comes into surface contact with the sliding surface 30a of the holder 30 is surrounded by the magnetic body 80. In other words, the bottom surface 27 of the holder base 20 is located inside the circular magnetic body 80 when viewed in the direction along the axis B.

The sample holder 104 can achieve the same functions/effects as those achieved by the sample holder 100.

### 1.4.5. Fifth Modification

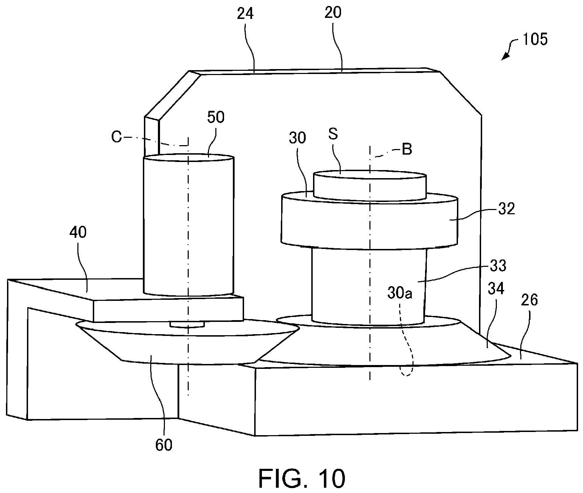

FIG. 10 is a perspective view schematically illustrating a sample holder 105 according to a fifth modification. Hereinbelow, in the sample holder 105, members having the same functions as those of the constituent members of the sample holder 100 described above are denoted by the same reference signs, and a detailed description thereof is omitted.

As illustrated in FIG. 10, in the sample holder 105, the first gear 60 and the second gear 34 are bevel gears.

Each of the first gear 60 and the second gear 34 is the bevel gear in which a plurality of teeth are formed in a side surface of a truncated cone. The first gear 60 and the second gear 34 are in upside down relation. In the illustrated example, the first gear 60 is disposed such that a top surface with a small area is at the bottom and a bottom surface with a large area is at the top, while the second gear 34 is disposed such that a top surface is at the top and a bottom surface is at the bottom. An axis C serving as a rotation axis of the first gear 60 and the axis B serving as a rotation axis of the second gear 34 are parallel to each other.

By using the first gear 60 and the second gear 34 which are thus in upside down relation, on the second gear 34 to which power has been transmitted from the first gear 60, a force to press the sliding surface 30a of the holder 30 against the holder base 20 acts. Accordingly, in the sample holder 105, not only the magnetic force from the magnet 70, but also a force generated by the second gear 34 as a result of transmission of power from the first gear 60 allow the sliding surface 30a to be brought into close contact with the holder base 20.

The sample holder 105 can achieve the same functions/effects as those achieved by the sample holder 100. In addition, in the sample holder 105, the second gear 34 generates the force to press the sliding surface 30a of the holder 30 against the holder base 20 with the power transmitted from the first gear 60. Consequently, in the sample holder 105, it is possible to bring the sliding surface 30a into closer contact with the holder base 20 and improve the efficiency of cooling of the holder 30.

While the description has been given above of a case where the first gear 60 and the second gear 34 are the bevel gears, the first gear 60 and the second gear 34 are not particularly limited as long as the second gear 34 generates the force to press the sliding surface 30a against the holder base 20.

For example, the first gear 60 and the second gear 34 may also be helical gears having helical tooth traces with respect to rotation axes. This allows the second gear 34 to generate the force to press the sliding surface 30a against the holder base 20 in the same manner as in a case where the first gear 60 and the second gear 34 are bevel gears. In addition, by using the helical gears as the first gear 60 and the second gear 34, it is possible to allow the holder 30 to be detachable.

### 1.4.6. Sixth Modification

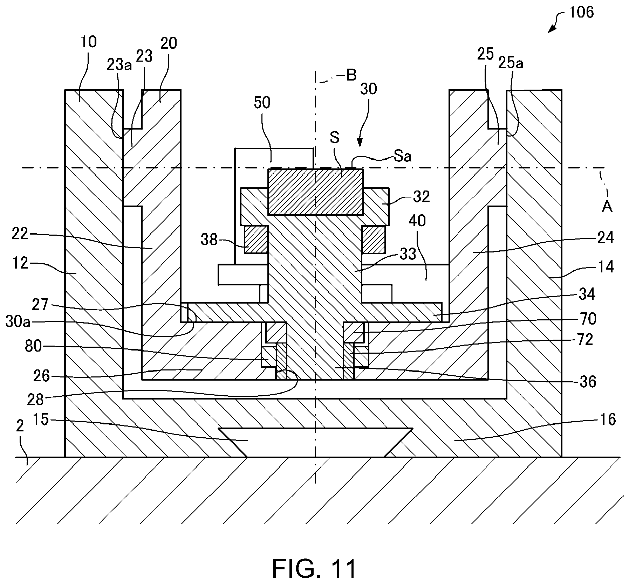

FIG. 11 is a cross-sectional view schematically illustrating a sample holder 106 according to a sixth modification. Hereinbelow, in the sample holder 106, members having the same functions as those of the constituent members of the sample holder 100 described above are denoted by the same reference signs, and a detailed description thereof is omitted.

As illustrated in FIG. 11, the sample holder 106 includes a heater 38 disposed on the holder 30.

The first wall portion 22 and the second wall portion 24 are thermally connected to the base 10 thermally connected to the cooling source 2, and are accordingly cooled by heat transfer. The sample S held herein by the sample holding portion 32 is disposed between the first wall portion 22 and the second wall portion 24. Therefore, it is possible to allow the first wall portion 22 and the second wall portion 24 to function as a cooling trap that adsorbs molecules of hydrocarbon or the like serving as a contamination source for the sample S and reduces sample contamination.

The heater 38 is a heater for heating the sample S. The heater 38 is attached to the holder 30. In the illustrated example, the heater 38 is disposed so as to come into contact with the sample holding portion 32, but a position at which the heater 38 is to be attached is not particularly limited. The heater 38, which is attached to the holder 30, can raise a temperature of the sample S held by the sample holding portion 32 before raising temperatures of the first wall portion 22 and the second wall portion 24. To the holder 30, a thermometer for measuring the temperature of the sample S may also be attached, though not shown. This allows the temperature of the sample S to be known.

To the stage of the sample processing apparatus, a heater for heating the sample holder 100 is attached, though not shown.

In the sample holder 106, when the sample S is processed by applying the ion beam to the sample S, while the sample S is cooled, the first wall portion 22 and the second wall portion 24 are allowed to function as the cooling trap. Accordingly, it is possible to reduce contamination of the sample S.

In the sample holder 106, the heater 38 attached to the holder 30 is included, and can therefore independently heat the holder 30. Thus, it is possible to prevent molecules adsorbed by the first wall portion 22 and the second wall portion 24, each functioning as the cooling trap, to serve as the contamination source from adhering again to the sample S.

For example, in the sample holder 106, the sample S can be processed by applying the ion beam to the sample S, while the first wall portion 22 and the second wall portion 24 are cooled to function as the cooling trap. After the processing is ended, when the sample S is to be returned to a room temperature, the sample S is heated first with the heater 38 attached to the holder 30. Then, with the heater attached to the stage, the base 10 and the holder base 20 are heated. Thus, when the sample S is to be returned to the room temperature, the temperature of the sample S can constantly be set higher than the temperatures of the first wall portion 22 and the second wall portion 24. As a result, it is possible to prevent the molecules adsorbed by the first wall portion 22 and the second wall portion 24 to serve as the contamination source from adhering again to the sample S.

### 1.4.7. Seventh Modification

In the sample holder 100 illustrated in FIG. 3, the sliding surface 30a of the holder 30 and the bottom surface 27 of the holder base 20 may also be coated with a lubricant. The lubricant may also be held between the sliding surface 30a and the bottom surface 27. As the lubricant, e.g., a conductive lubricant such as an ionic liquid can be used. This can reduce friction between the holder 30 and the holder base 20 and improve the efficiency of cooling of the holder 30.

### 1.4.8. Eighth Modification

In the sample holder 100 illustrated in FIGS. 1 to 4, the first gear 60 is rotated by the rotation of the motor 50, and the power is transmitted from the first gear 60 to rotate the second gear 34, but a first rotation transmission member rotated by the rotation of the motor 50 and a second rotation transmission member rotated by the power transmitted thereto from the first rotation transmission member are not limited to the first gear 60 and the second gear 34.

It may also be possible to use pulleys as the first rotation transmission member connected to the motor 50 and the second rotation transmission member provided on the holder 30 and connect the first rotation transmission member and the second rotation transmission member with a belt. This can transmit the drive of the motor 50 to the holder 30 via the first rotation transmission member and the second rotation transmission member and rotate the holder 30.

### 2. Second Embodiment

### 2.1. Configuration of Sample Holder

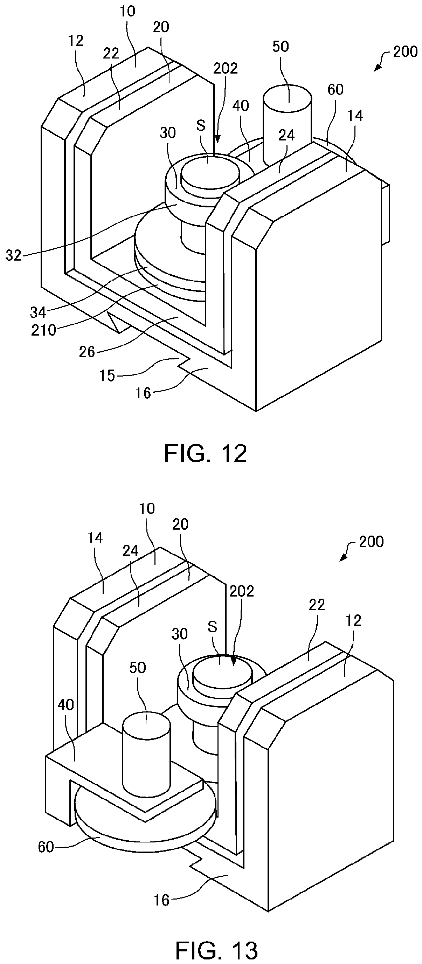

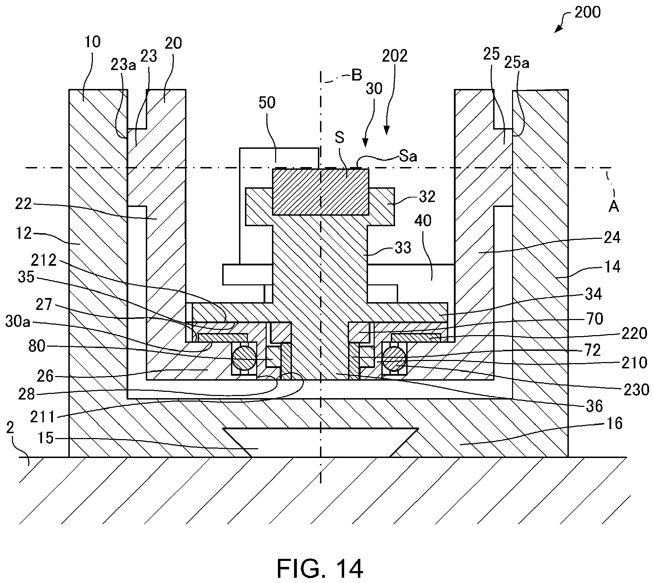

Next, referring to the drawings, a description will be given of a sample holder according to the second embodiment. FIGS. 12 and 13 are perspective views schematically illustrating a sample holder 200 according to the second embodiment. FIG. 14 is a cross-sectional view schematically illustrating the sample holder 200 according to the second embodiment. Hereinbelow, in the sample holder 200 according to the second embodiment, members having the same functions as those of the constituent members of the sample holder 100 according to the first embodiment are denoted by the same reference signs, and a detailed description thereof is omitted.

In the sample holder 100 described above, the rotating body rotatably supported on the holder base 20 is formed of the holder 30. By contrast, in the sample holder 200, as illustrated in FIGS. 12 to 14, a rotating body 202 includes the holder 30, a rotating base 210, and a multi-layer foil 220.

The sample holder 200 includes the rotating base 210, the multi-layer foil 220, and a bearing 230. The holder 30, the rotating base 210, and the multi-layer foil 220 are included in the rotating body 202 rotated by the drive of the motor 50.

The rotating base 210 is supported on the holder base 20 to be rotatable around the axis B serving as a rotation axis. The rotating base 210 is fixed into the hole 28 of the holder base 20 via the bearing 230. Thus, the rotating base 210 is rotatably supported on the holder base 20. The rotating base 210 rotates around the axis B serving as the rotation axis.

In the rotating base 210, a hole 211 is formed around the axis B serving as a center axis. Into the hole 211, the shaft portion 36 of the holder 30 is inserted. The holder 30 is in surface contact with the rotating base 210. A surface 35 of the holder 30 surrounded by the plurality of teeth of the second gear 34 is in surface contact with an upper surface 212 of the rotating base 210. To the rotating base 210, the magnetic body 80 is fixed. To the holder 30, the magnet 70 is fixed. Under an attraction force acting between the magnet 70 fixed to the holder 30 and the magnetic body 80 fixed to the rotating base 210, the surface 35 of the holder 30 is in close contact with the upper surface 212 of the rotating base 210.

The holder 30 is fixed to the rotating base 210 with the magnetic force generated by the magnet 70, and accordingly the holder 30 is detachable from the rotating base 210. The holder 30 and the rotating base 210 integrally rotate around the axis B serving as the rotation axis.

The multi-layer foil 220 is fixed to the rotating base 210. The multi-layer foil 220 rotates together with the rotating base 210. A surface of the multi-layer foil 220 has a circular shape around the axis B. The multi-layer foil 220 is, e.g., copper foils laminated in multiple layers. The multi-layer foil 220 is disposed between the rotating base 210 and the holder base 20.

The surface of the multi-layer foil 220 serves as the sliding surface 30a. In other words, the surface of the multi-layer foil 220 comes into slidable surface contact with the bottom surface 27 of the holder base 20. Compared to, e.g., bulk metal, the multi-layer foil 220 is more susceptible to elastic deformation. Accordingly, by using the surface of the multi-layer foil 220 as the sliding surface 30a, it is possible to rotate the rotating body 202, while bringing the sliding surface 30a into close contact with the holder base 20.

For example, when a surface of bulk metal with high rigidity is used as the sliding surface 30a, a frictional resistance increases when a position of the rotating base 210 is close to the holder base 20, and the rotating body 202 cannot rotate. Meanwhile, when the position of the rotating base 210 is away from the holder base 20, the rotating body 202 cannot be brought into close contact with the holder base 20, and the holder 30 cannot be cooled. When the surface of the bulk metal with the high rigidity is thus used as the sliding surface 30a, it is difficult to rotate the rotating body 202, while keeping the sliding surface 30a in close contact with the holder base 20. By contrast, by using the surface of the multi-layer foil 220 susceptible to elastic deformation as the sliding surface 30a, it is possible to rotate the rotating body 202, while keeping the sliding surface 30a in close contact with the holder base 20.

Note that the multi-layer foil 220 needs only to be disposed between the rotating base 210 and the holder base 20. Accordingly, it may also be possible to fix the multi-layer foil 220 to the holder base 20 and use the bottom surface 27 of the holder base 20 as the surface of the multi-layer foil 220.

While the description has been given herein of the case where the multi-layer foil 220 is used as a member to be used as the sliding surface 30a, the member to be used as the sliding surface 30a is not limited to the multi-layer foil 220. The member to be used as the sliding surface 30a needs only to be an elastic body having a high heat conductivity and susceptible to elastic deformation, and may also be a flat stranded wire made of copper or the like.

In the sample holder 200, when the rotating body 202 is fixed to the holder base 20 via the bearing 230, a force with which the sliding surface 30a of the rotating body 202 presses the holder base 20 can be adjusted depending on the position at which the rotating body 202 is to be fixed.

### 2.2. Operation

An operation of the sample holder 200 is the same as the operation of the sample holder 100 except that the rotating body 202 including the holder 30, the rotating base 210, and the multi-layer foil 220 is rotated by the drive of the motor 50, and a description thereof is omitted.

### 2.3. Functions/Effects

In the sample holder 200, the rotating body 202 includes the holder 30 that holds the sample S, the rotating base 210 that detachably holds the holder 30 and is rotatably supported on the holder base 20, and the multi-layer foil 220 having the surface serving as the sliding surface 30a. In addition, in the sample holder 200, the rotating base 210 is rotatably supported on the holder base 20 via the bearing 230. Consequently, in the sample holder 200, it is possible to bring the sliding surface 30a of the rotating body 202 into slidable surface contact with the holder base 20, while rotatably supporting the rotating body 202 via the bearing 230. Therefore, the sample holder 200 can achieve the same functions/effects as those achieved by the sample holder 100.

### 3. Third Embodiment

### 3.1. Sample Processing Apparatus

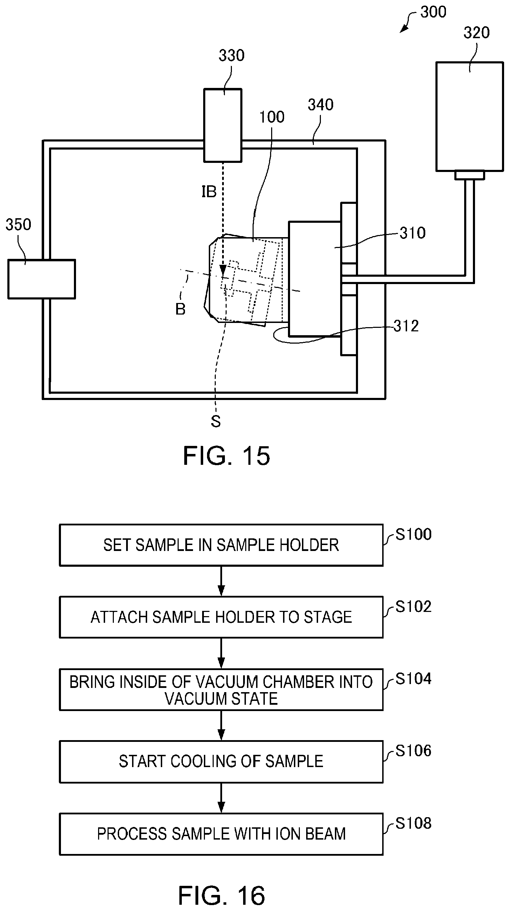

Next, referring to the drawings, a description will be given of a sample processing apparatus according to the third embodiment. FIG. 15 is a diagram illustrating a configuration of a sample processing apparatus 300 according to the third embodiment.

The sample processing apparatus 300 can produce a sample for a scanning electron microscope by applying an ion beam IB to the sample S and processing the sample S. The sample processing apparatus 300 can process the sample S by planar surface milling in which the ion beam IB is obliquely applied to the surface Sa of the sample S.

The sample processing apparatus 300 includes the sample holder 100 illustrated in FIGS. 1 to 4, a stage 310, a liquid nitrogen tank 320, an ion source 330, a vacuum chamber 340, and a camera 350.

The sample holder 100 is attached to the stage 310. In the example illustrated in FIG. 15, an attachment surface 312 of the stage 310 to which the sample holder 100 is to be attached faces a horizontal direction. The sample holder 100 is attached to the attachment surface 312 such that the bottom portion 16 of the base 10 comes into surface contact with the attachment surface 312. The sample holder 100 is attached to the attachment surface 312 of the stage 310 such that the axis A serving as the inclination axis illustrated in FIG. 3 is horizontal. To an intersection of the axis A with the axis B, the ion beam IB is applied.

The stage 310 is thermally connected via a heat transfer portion interposed between the stage 310 and the liquid nitrogen tank 320 in which liquid nitrogen serving as a refrigerant is pooled. Accordingly, it is possible to cool the stage 310 and cause the stage 310 to function as the cooling source 2. In addition, to the stage 310, a connection/disconnection mechanism for switching between connection and disconnection in the heat transfer portion connected to the liquid nitrogen tank and a heater for heating the stage 310 are attached, though not illustrated. As a result, in the sample processing apparatus 300, a temperature of the stage 310 can be controlled to an intended temperature.

In the sample holder 100, by using the axis A as the inclination axis, the holder base 20 can be inclined. Thus, by inclining the holder base 20, it is possible to adjust the incidence angle of the ion beam IB with respect to the surface Sa of the sample S.

The ion source 330 applies the ion beam IB to the sample S. The ion source 330 is attached to an upper portion of the vacuum chamber 340. For example, the ion source 330 is an ion gun that accelerates the ion beam IB with a predetermined acceleration voltage to emit the ion beam IB. For example, the ion source 330 ionizes argon gas to emit the argon ion beam IB.

In the vacuum chamber 340, the sample holder 100 is contained. In the vacuum chamber 340, to the sample S held on the sample holder 100, the ion beam IB is applied. The vacuum chamber 340 is internally evacuated by using an exhaust device not shown.

The camera 350 is a camera for observing the sample S held on the sample holder 100. The camera 350 allows a status of processing of the sample S to be checked.

### 3.2. Sample Processing Method

### 3.2.1. Planar Surface Milling

In the sample processing apparatus 300, the surface Sa of the sample S can be processed by the planar surface milling. The planar surface milling is a technique of obliquely applying the ion beam IB to the surface Sa of the rotating sample S to process the surface Sa of the sample S. For example, in or to the surface Sa of the sample S subjected to preprocessing by mechanical polishing, a polishing flaw, crystal distortion, or the like occurs or a residue of an abrasive adheres, and accordingly it is difficult to obtain information on a state or unevenness of an outermost surface of the sample by using the scanning electronic microscope. By performing the planar surface milling as a final finish on the mechanically polished surface of the sample, it is possible to remove the polishing flaw, the residue of the abrasive, the crystal distortion, or the like in a wide range.

For example, when the ion beam IB is applied at a shallow angle of 10 degrees or less to the surface Sa of the sample S, a less uneven surface at which an etching rate difference due to a crystal orientation or a composition has been reduced can be obtained. This allows an image with an enhanced channeling contrast to be observed in the scanning electron microscope. Meanwhile, when the ion beam IB is applied at a deep angle of 30 degrees or more to the sample surface, an etching rate difference due to the crystal orientation or composition is produced, and therefore an image with enhanced unevenness can be observed in the scanning electron microscope.

### 3.2.2. Flow of Sample Processing

FIG. 16 is a flow chart illustrating an example of a sample processing method using the sample processing apparatus 300 including the sample holder 100. Hereinbelow, referring to FIGS. 1 to 4 and FIG. 15, a description will be given of a case where the planar surface milling is performed on the sample S.

First, the sample S is set in the sample holder 100 (S100). In the sample holder 100, the holder 30 is detachable from the holder base 20. Accordingly, it is possible to detach the holder 30 from the holder base 20 and fix the sample S to the holder 30. Specifically, as illustrated in FIG. 3, the sample S is fixed to the sample holding portion 32 such that the intersection of the axis A with the axis B is located at a center of the surface Sa of the sample S. After the sample S is fixed to the sample holding portion 32, the holder 30 is attached to the holder base 20.

Note that, in the sample holder 100, the holder 30 is detachable, and accordingly it may also be possible to prepare a plurality of the holders 30 at different heights and use the holder 30 according to the height of the sample S.

Next, as illustrated in FIG. 15, the sample holder 100 is attached to the stage 310 (S 102). At this time, the position of the sample holder 100 with respect to an optical axis of the ion source 330 is adjusted such that the ion beam IB is applied to the intersection of the axis A with the axis B. In addition, the incidence angle of the ion beam IB with respect to the surface Sa of the sample S is adjusted. The adjustment of the incidence angle of the ion beam IB with respect to the surface Sa of the sample S is performed by inclining the holder base 20 by using the axis A as the inclination axis.

Next, the vacuum chamber 340 is internally evacuated to bring the inside of the vacuum chamber 340 into a vacuum state (depressurized state) (S104).

Next, cooling of the sample S is started (S 106). By supplying the liquid nitrogen to the liquid nitrogen tank 320, the stage 310 can be cooled. By the cooling of the stage 310, the base 10 thermally connected to the stage 310 and the holder base 20 thermally connected to the base 10 are cooled. In addition, since the holder base 20 and the holder 30 are in surface contact with each other, the holder 30 is also cooled. Thus, the sample S can be cooled. It may also be possible to operate the heater attached to the stage 310 and thereby control the temperature of the sample S.

Next, the sample S is processed with the ion beam IB (S 108). By operating the motor 50, the holder 30 is continuously rotated in the given direction around the axis B serving as the rotation axis via the first gear 60 and the second gear 34. As a result of the rotation of the holder 30, the sliding surface 30a of the holder 30 slides, while being kept in surface contact with the bottom surface 27 of the holder base 20. In addition, by the magnetic force generated by the magnet 70, the sliding surface 30a is pressed against the bottom surface 27. Accordingly, even when the holder 30 is rotated, the holder 30 can efficiently be cooled. Furthermore, due to the magnetic force generated by the magnet 70, the sliding surface 30a is pressed against the bottom surface 27 with a predetermined force, and consequently fluctuations in contact thermal resistance can be reduced to allow the temperature of the sample S to be held constant.

In a state where the sample S is rotated, the ion source 330 is caused to emit the ion beam IB, and the ion beam IB is applied to the surface Sa of the sample S. Thus, it is possible to apply the ion beam IB to the sample S and process the surface Sa of the sample S, while rotating and cooling the sample S. By the foregoing steps, the planar surface milling can be performed on the sample S.

After the processing of the sample S is ended, the stage 310 is heated with the heater attached to the stage 310 to return the sample holder 100 to a room temperature. As a result, it is possible to retrieve the sample holder 100 from within the vacuum chamber 340.

Note that, while the description has been given above of a case where the sample S is processed by the planar surface milling using the sample processing apparatus 300, the sample S can also be processed using the sample processing apparatus 300 and a technique other than the planar surface milling.

### 3.3. Functions/Effects

The sample processing apparatus 300 includes the sample holder 100, and therefore it is possible to produce an excellently smooth surface by the planar surface milling even when the sample S is a polymer or low-melting-point metal sample or the like sensitive to heat.

### 3.4. Modifications

### 3.4.1. First Modification

In the third embodiment described above, the description has been given of the case where the sample processing apparatus 300 includes the sample holder 100, but the sample processing apparatus 300 may also include, e.g., a sample holder 106 illustrated in FIG. 11. This allows the first wall portion 22 and the second wall portion 24 to be used as a cooling trap in Step S 108 of processing the sample S with the ion beam IB. In addition, when the sample holder 100 is to be retrieved from the vacuum chamber 340, after the temperature of the holder 30 is increased with the heater 38, the holder base 20 can be heated with the heater attached to the stage 310. This can prevent molecules adsorbed by the first wall portion 22 and the second wall portion 24 to serve as a contamination source from adhering again to the sample S.

Note that the sample processing apparatus 300 may also include the other sample holders 101, 102, 103, 104, 105, and 200 described above.

### 3.4.2. Second Modification

In the third embodiment described above, the description has been given of the case where the sample processing apparatus 300 includes the ion source 330 that applies the ion beam IB to the sample S, but the sample processing apparatus 300 may also include a charged particle beam source that applies a charged particle beam other than the ion beam IB, such as an electron beam, to the sample S.

Note that the embodiments and modifications described above are examples, and are not limited thereto. For example, the individual embodiments and the individual modifications can appropriately be combined with each other.

The invention is not limited to the above-described embodiments, and various modifications can be made. For example, the invention includes configurations that are substantially the same as the configurations described in the embodiments. Substantially same configurations mean configurations having the same functions and methods, for example. The invention also includes configurations obtained by replacing non-essential elements of the configurations described in the embodiments with other elements. The invention further includes configurations obtained by adding known art to the configurations described in the embodiments.

## Claims

1. A sample holder used for a sample processing apparatus that applies a charged particle beam to a sample to process the sample, the sample holder comprising:
a holder base thermally connected to a cooling source;
a rotating body rotatably supported on the holder base to hold the sample; and
a drive unit that rotates the rotating body, and
the rotating body having a sliding surface that comes into slidable surface contact with the holder base.

2. The sample holder according to claim 1, further comprising:
a magnet that brings the rotating body into close contact with the holder base by a magnetic force generated by the magnet.

3. The sample holder according to claim 2, wherein
the magnet is fixed to the rotating body, and
a magnetic body is fixed to the holder base.

4. The sample holder according to claim 2, wherein
the magnet is fixed to the holder base, and
a magnetic body is fixed to the rotating body.

5. The sample holder according to claim 3 or 4, wherein a distance between the magnet and the magnetic body is variable.

6. The sample holder according to any one of claims 1 to 5, further comprising:
a first rotation transmitting member that is rotated by rotation of the drive unit, wherein
the rotating body includes:
a sample holding portion that holds the sample; and
a second rotation transmitting member that is rotated by power transmitted from the first rotation transmitting member to the second rotation transmitting member.

7. The sample holder according to claim 6, wherein the sliding surface is a surface of the second rotation transmitting member.

8. The sample holder according to claim 6 or 7, wherein
the first rotation transmitting member is a first gear, and
the second rotation transmitting member is a second gear that meshes with the first gear.

9. The sample holder according to claim 8, wherein, when viewed in a direction along a rotation axis of the rotating body, a maximum diameter of the second gear is larger than a maximum width of the sample holding portion.

10. The sample holder according to claim 8 or 9, wherein a plurality of teeth of the second gear are formed around the sliding surface.

11. The sample holder according to any one of claims 8 to 10, wherein the second gear generates a force to press the sliding surface against the holder base by the power transmitted from the first gear to the second gear.

12. The sample holder according to any one of claims 1 to 11, wherein
the holder base has a first wall portion and a second wall portion, and,
the sample is disposed between the first wall portion and the second wall portion.

13. The sample holder according to claim 12, further comprising:
a heater attached to the rotating body.

14. The sample holder according to any one of claims 1 to 13, wherein the rotating body includes:
a holder that holds the sample;
a rotating base that detachably holds the holder and is rotatably supported on the holder base; and
a multi-layer foil having a surface serving as the sliding surface.

15. The sample holder according to claim 14, wherein the rotating base is rotatably supported on the holder base via a bearing.

16. The sample holder according to any one of claims 1 to 15, wherein the drive unit continuously rotates the rotating body in a predetermined direction.

17. The sample holder according to any one of claims 1 to 16, further comprising:
a base thermally connected to the cooling source, wherein
the holder base is thermally connected to the cooling source via the base, and
the holder base is connected to the base to be able to be inclined.

18. A sample processing apparatus comprising:
the sample holder according to any one of claims 1 to 17; and
a charged particle beam source that applies a charged particle beam to the sample held on the sample holder.
